# EUROPEAN PATENT SPECIFICATION

(11) **EP 3 719 388 B1**
(45) Date of publication and mention of the grant of the patent: **05.07.2023**
(21) Application number: 18904336.7
(22) Date of filing: 10.12.2018
(51) Int. Cl.: F21S 8/00, G02F 1/1333, F21V 17/10, F21V 8/00

(54) **BACKLIGHT MODULE AND ELECTRONIC DEVICE**
HINTERGRUNDBELEUCHTUNGSMODUL UND ELEKTRONISCHE VORRICHTUNG
MODULE DE RÉTROÉCLAIRAGE ET DISPOSITIF ÉLECTRONIQUE

(30) Priority: 31.01.2018 CN 201810106256; 31.01.2018 CN 201820181747 U
(43) Date of publication of application: 07.10.2020
(73) Proprietor: GUANGDONG OPPO MOBILE TELECOMMUNICATIONS CORP., LTD., Wusha, Chang'an Dongguan, Guangdong 523860 (CN)
(72) Inventor: OUYANG, Zhibin, Dongguan, Guangdong 523860 (CN)
(74) Representative: Manitz Finsterwald Patent- und Rechtsanwaltspartnerschaft mbB
(86) International application number: PCT/CN2018/120028
(87) International publication number: WO 2019/148967

(56) References cited:
- CN-A- 101 126 857
- CN-A- 103 438 386
- CN-A- 103 438 386
- CN-A- 105 717 707
- CN-A- 108 087 794
- CN-U- 202 972 962
- CN-U- 206 301 120
- CN-U- 208 107 763
- US-A1- 2008 297 687
- US-B1- 8 681 290

## Description

### TECHNICAL FIELD

The present disclosure relates to the field of electronic devices, and in particular to a backlight module and an electronic device.

### BACKGROUND

A backlight module of an electronic device may include an optical assembly and a backlight source. During assembling, a distance between a light guide plate of the optical assembly and the backlight source may be too large, such that the light guide plate may not be able to receive light emitted from the backlight source completely, and a backlight effect of the light guide plate may be reduced. CN 103 438 386 A discloses a light source device including a light source assembly, a light guide plate, a radiating element and a positioning element. The light guide plate is arranged beside the light source assembly. The radiating element is connected to the light source assembly. The positioning element has a base which is located below the light guide plate and a positioning part which is connected to the base, and the positioning element is arranged on the radiating element, the corner of the light guide plate near to the light source assembly is supported against the positioning part, and the base is fixed on the light source assembly. The light source assembly is fixed on the radiating element by the positioning element, and the radiating element is fixed on a back plate, so that the tolerance during assembly is reduced, and the distance between the light guide plate and the light source assembly is precisely maintained. CN 206 301 120 U discloses a backlight unit including the light guide plate and sets up in the light source of light guide plate side. Backlight unit still includes the backplate, and the at least one end of backplate is provided with U type holding portion, and U type holding portion is including relative bottom plate and the roof that sets up to and be located the curb plate between bottom plate and the roof, wherein, the roof is close to backlight unit's light - emitting side, the side surface that the roof deviates from the bottom plate is provided with the depressed part. Backlight unit still includes reflection configuration, and reflection configuration includes fixed part and reflecting part, and the fixed part is located the depressed part, the reflecting part stretches out above -mentioned roof along the orientation that deviates from the curb plate, just is used for reflecting the emergent ray of light source. This backlight unit is used for providing in a poor light. US 2008/297687 A1 teaches a light source, which can efficiently be housed even if the area of the substrate increases while giving extra consideration to the heat radiation of the light emitting diodes in a liquid crystal display device using the light emitting diodes as a light source. A plate-like light source section is formed by arranging the light emitting diodes on a metal substrate. The plate-like light source section is formed to have a larger area than an entrance surface of a light guide plate, and is disposed so as to face the entrance surface of the light guide plate. The light guide plate and the plate-like light source section are housed in a housing case, and the housing case is formed to have a larger depth in a part for housing the plate-like light source section than in a part for housing the light guide plate. A cushion member is provided between the light guide plate and the housing case to prevent the light guide plate from being moved by vibrations. US 2008/297687 A1 further teaches a LED comprises a wall member arranged on the side of the light guide plate and a LED chip which is a light emitting element. Further, the wall member defines a groove in which a fluorescent material is arranged, the light emitting element is received in the groove and is configured to emit light to the light guide plate through the groove.

### SUMMARY OF THE DISCLOSURE

According to a first aspect of the present disclosure, a backlight module is provided as set out in claims 1 to 11.

According to a second aspect of the present disclosure, an electronic device is provided as set out in claim 12.

According to the present disclosure, a light guide plate is arranged with a first positioning portion, and a positioning member is arranged with a second positioning portion engaged with the first positioning portion. In such a way, when assembling an optical assembly, the first positioning portion and the second positioning portion are engaged to achieve positioning, and the optical assembly is disposed into a receiving space, such that a distance between the backlight source and the light guide plate is less than or equal to a threshold. A situation of the distance between the backlight source and the light guide plate being too long may be avoided, and a situation of the light guide plate unable to completely receive the light emitted from the backlight source due to the distance being too long may be prevented, improving the backlight efficiency, improving assembling precision, and reducing a difficulty of assembling.

### BRIEF DESCRIPTION OF THE DRAWINGS

In order to illustrate technical solutions of embodiments of the present disclosure in details, drawings required for illustrating the embodiments will be described in brief. Obviously, the following drawings illustrate only some embodiments of the present disclosure, and to any one of skill in the related art, other drawings may be obtained based on the following drawings without any creative work.
FIG. 1 is a structural schematic view of a backlight module according to a first embodiment of the present disclosure.
FIG. 2 is a schematic view of a cross section of the embodiment shown in FIG. 1, taken along a line of II-II.
FIG. 3 is a schematic view of a cross section of the embodiment shown in FIG. 1, taken along a line of III-III.
FIG. 4 is an assembly schematic view of a light-shielding tape and a back frame according to an embodiment of the present disclosure.
FIG. 5 is a cross-sectional view of a backlight module according to a second embodiment of the present disclosure.
FIG. 6 is a schematic view of the back frame shown in FIG. 5 of the present disclosure.
FIG. 7 is a schematic view of an electronic device according to an embodiment of the present disclosure.

### DETAILED DESCRIPTION

The present disclosure will be further illustrated in details by referring to drawings and embodiments. Specifically, following embodiments are for the purpose of illustrating the present disclosure, but do not limit the scope of the present disclosure. Similarly, the following embodiments are only a part of, but not all of, the embodiments of the present disclosure.

The term "embodiment" indicates that specific characteristics, structures, or properties described in an embodiment may be included in at least one embodiment of the present disclosure. The expression "embodiment" appearing in various sections of the present specification may not indicate a same embodiment, and may not indicate an independent or alternative embodiment mutually exclusive of other embodiments. Any one of skill in the art should implicitly and explicitly understand that the embodiments described herein can be combined with other embodiments.

According to a first aspect of the present disclosure, a backlight module is provided and includes: a back frame, an optical assembly, a backlight source, and a positioning member. The back frame includes a side wall and a bottom wall, and the side wall and the bottom wall are connected to each other and define a receiving space. The optical assembly is arranged on the bottom wall and received in the receiving space, and includes a light guide plate. The light guide plate defines a recess. The backlight source comprises a lamp and a flexible circuit board. The lamp is arranged on and extends along a side of the light guide plate close to the side wall. The positioning member is arranged to connect to the back frame and at least partially received in the receiving space. The positioning member comprises a positioning portion. The positioning portion is engaged into the recess, and an extending direction of the positioning portion is parallel to an extending direction of the lamp, such that a distance between the light guide plate and the backlight source is less than or equal to a threshold.

According to the claimed invention, the positioning member includes a body portion and an extension portion. The body portion is arranged to connect to the back frame, and the extension portion is arranged to extend from the body portion towards the receiving space. The second positioning portion is arranged on the extension portion.

According to the claimed invention, at least two side walls are arranged and connected to each other. The body portion is arranged at a position at which the at least two side walls are connected to each other, and the extension portion is arranged to extend from the body portion towards a position between the light guide plate and at least one of the at least two side walls.

In some embodiment, the positioning portion is arranged to perpendicularly protrude from an end of the extension portion away from the body portion.

In some embodiments, the back frame further includes a top wall. The top wall and an end of the side wall away from the bottom wall are connected to each other. The top wall, the side wall, and the bottom wall cooperatively define the receiving space. The positioning member is arranged on a side of the top wall away from the receiving space and is arranged to align with the top wall.

In some embodiments, the threshold is less than or equal to 0.1mm.

In some embodiments, the flexible circuit board is adhered to a side of the lamp away from the light guide plate.

In some embodiments, the light guide plate includes a light incidence surface and a light emitting surface. The lamp is arranged on the light incidence surface of the light guide plate and at an optimized position for light emitting.

In some embodiments, the optimized position for light emitting is an optimized position of the lamp in height and in distance relative to the light guide plate, such that emitted light may be completely received by the light guide plate.

In some embodiments, a first adhesion member is arranged between the lamp and the bottom wall, and the lamp is adhered to the bottom wall via the first adhesion member, such that the lamp is arranged at the optimized position in height relative to the light guide plate by providing the first adhesion member in an appropriate thickness.

In some embodiments, a second adhesion member is arranged between the lamp and the side wall, and the lamp is adhered to the side wall via the second adhesion member, such that the lamp is arranged at the optimized position in distance relative to the light guide plate by providing the second adhesion member in an appropriate thickness.

In some embodiments, the receiving space includes a first space and a second space communicating with each other, the first space and the second space are sequentially defined along a direction facing towards the side wall. The optical assembly is received in the first space. An area of a cross section of the second space taken along the direction facing towards the side wall is greater than that of the first space taken along the facing towards the side wall, and the lamp is received in the second space.

In some embodiments, the optical assembly further includes an optical film assembly arranged on the light emitting surface of the light guide plate. The backlight module further includes a light-shielding tape, and the light-shielding tape is arranged on a side of the top wall away from the receiving space and adhered to the top wall and the optical film assembly.

In some embodiments, the light-shielding tape is further arranged on a side of the side wall away from the receiving space and adhered to the side wall.

According to a third aspect of the present disclosure, an electronic device is provided and includes a display module and the above-mentioned backlight module. The display module is arranged to stack above the backlight module.

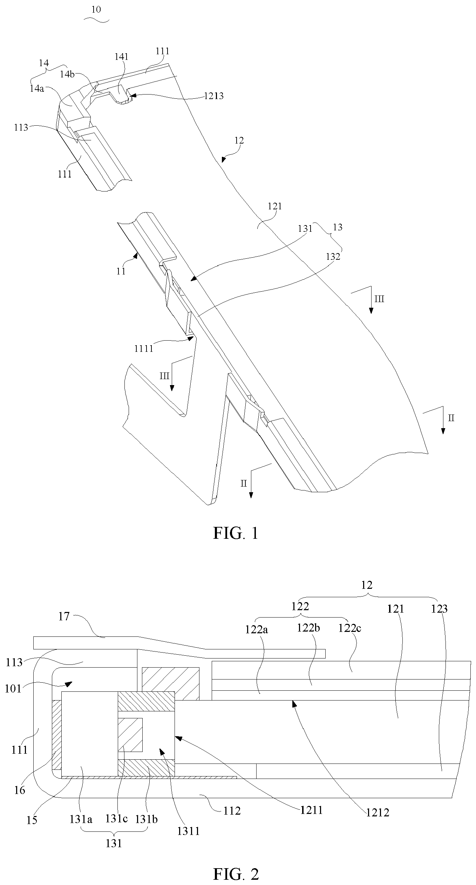

As shown in FIG. 1, a structural schematic view of a backlight module 10 according to a first embodiment is provided. The backlight module 10 of the present embodiment includes a back frame 11, an optical assembly 12, a backlight source 13, and a positioning member 14.

As shown in FIG. 1 and FIG. 2, the back frame 11 includes a side wall 111 and a bottom wall 112, and the side wall 111 and the bottom wall 112 are bent to connect to each other and define a receiving space 101.

Moreover, at least two side walls 111 are arranged, and the at least two side walls 111 may be bent to connect to each other.

Alternatively, the back frame 11 may further include a top wall 113. The top wall 113 and an end of the side wall 111 away from the bottom wall 112 may be bent to connect to each other. The top wall 113, the side wall 111, and the bottom wall 112 may cooperatively define the receiving space 101. The top wall 113 may be arranged to carry a display module when the backlight module 10 is assembled with the display module of an electronic device.

Further, as shown in FIG. 1, the back frame 11 may define an opening 1111 communicating with the receiving space 101.

Alternatively, the back frame 11 may be a metal back frame.

The optical assembly 12 is received in the receiving space 101 and arranged on the bottom wall 112.

The optical assembly 12 includes a light guide plate 121. The light guide plate 121 may include a light incidence surface 1211 and a light emitting surface 1212. The light incidence surface 1211 may be a surface of the light guide plate 121 close to the side wall 111, and the light emitting surface 1212 may be a surface of the light guide plate 121 away from the bottom wall 112. As shown in FIG. 1, the light guide plate 121 is arranged with a first positioning portion 1213.

According to the claimed invention, the first positioning portion 1213 may be a recess.

Further, the optical assembly 12 may further include an optical film assembly 122 and a reflection sheet 123. The optical film assembly 122 may be arranged on the light guide plate 121 and may specifically be on the light emitting surface 1212 of the light guide plate 121. The reflection sheet 123 may be arranged on the bottom wall 112, facing towards a side of the light guide plate 121 away from the light emitting surface 1212.

The optical film assembly 122 may include a diffusion film 122a, a lower transmission increasing film 122b, and an upper transmission increasing film 122c sequentially stacked along a direction away from the light guide plate 121.

The backlight source 13 is arranged on a side of the light guide plate 121 close to the side wall 111. Specifically, the backlight source 13 is arranged on a side of the light guide plate 121 close to one of the at least two side walls 111.

In the present embodiment, the backlight source 13 includes a lamp 131, serving as a light source, and a flexible circuit board 132.

The lamp 131 is arranged on the side of the light guide plate 121 close to the side wall 111. Specifically, the lamp 131 may be arranged on the light incidence surface 1211 of the light guide plate 121 and emit light to the light guide plate 121 through the light incidence surface 1211.

The lamp 131 may include a printed circuit board (PCB) 131a, an encapsulation member 131b, and a light emitting element 131c. The PCB 131a may be arranged on the side of the light guide plate 121 close to the side wall 111. The encapsulation member 131b may be arranged on a side of the PCB 131a close to the light guide plate 121 and connected to the PCB 131a. The encapsulation member 131b may define an encapsulation groove 1311. The light emitting element 131c may be adhered to the PCB 131a and may be received in the encapsulation groove 1311. The light emitting element 131c may emit the light to the light guide plate 121 through the encapsulation groove 1311.

Alternatively, the light emitting element 131c may be an LED chip.

Further, the lamp 131 may be arranged at an optimized position for light emitting relative to the light guide plate 121.

The optimized position for light emitting may be a position of the lamp 131 from which the light emitted by the lamp 131 may be completely received by the light guide plate 121. The optimized position may be an optimized position in height and in distance. It may be understood that, when the lamp 131 is arranged at a position being too high or too low along a direction perpendicular to the bottom wall 112, the light guide plate 121 may be unable to receive the light emitted from the lamp 131 completely. When a distance between the lamp 131 and the light guide plate 121 is too long, the light emitted from the lamp 131 may escape from the light guide plate 121, and therefore, the light may not be completely received by the light guide plate 121, such that utilization of the light 131 and the backlight effect of the light guide plate 121 may be reduced.

Alternatively, the light emitting element 131c of the lamp 131 may be arranged on a central line of the light guide plate 121.

Alternatively, a first adhesion member 15 may be arranged between the lamp 131 and the bottom wall 112. The lamp 131 may be adhered to the bottom wall 112 via the first adhesion member 15, enabling the lamp 131 to be arranged at an optimized height relative to the light guide plate 121. That is, in the present embodiment, when the lamp 131 is adhered on the bottom wall 112 and fixed relative to the bottom wall 112 via the first adhesion member 15, a thickness of the first adhesion member 15 may be adjusted to enable the light emitting element 131c of the lamp 131 to be arranged at the optimized height relative to the light guide plate 121 (i.e., arranged to align with the central line of the light guide plate 121), such that utilization of the light source 131 and the backlight effect of the light guide plate 121 may be improved.

Alternatively, the first adhesion member 15 may be a double-sided tape.

Alternatively, a second adhesion member 16 may be arranged between the lamp 131 and the side wall 111. The lamp 131 may be adhered to the side wall 111 via the second adhesion member 16, enabling the lamp 131 to be arranged at an optimized distance relative to the light guide plate 121. That is, in the present embodiment, when the lamp 131 is adhered on the side wall 111 and fixed relative to the side wall 111 via the second adhesion member 16, a thickness of the second adhesion member 16 may be adjusted to enable the lamp 131 to be arranged at the optimized distance relative to the light guide plate 121, such that utilization of the light source 131 and the backlight effect of the light guide plate 121 may be improved.

As shown in FIG. 1, FIG. 2, and FIG. 3, the flexible circuit board 132 may be arranged to adhere to the lamp 131 on a side of the lamp 131 away from the light guide plate 121, such that a space for soldering the flexible circuit board 132 with the lamp 131 may not be required along a direction facing towards the side wall 111. Therefore, the space may be saved along a direction perpendicular to the side wall 111, a width of the backlight module 10 along the direction perpendicular to the side wall 111 may be reduced, and a narrow-sided backlight module maybe achieved.

Specifically, the flexible circuit board 132 may be adhered to a side of the PCB 131a away from the light emitting element 131c. As shown in FIG. 1, the flexible circuit board may extend through the opening 1111 to reach a side of the back frame 11 away from the receiving space 101.

The flexible circuit board 132 and the second adhesion member 15 may both be adhered to the PCB 131a.

The positioning member 14 is connected to the back frame 11 and at least partially received in the receiving space 101.

Specifically, the positioning member 14 includes a body portion 14a and an extension portion 14b. The body portion 14a is connected to the back frame 11. The extension portion 14b extends from the body portion 14a towards the receiving space 101. In FIG. 1, the body portion 14a is received in the receiving space 101 and connects to the back frame 11. The extension portion 14b may extend from a part of the body portion 14a received in the receiving space 101.

The body portion 14a is arranged at a position of which the at least two side walls 111 are bent and connected. The extension portion 14b extends from the body portion 14a towards a position between the light guide plate 121 and at least one of the at least two side walls 111. In the present embodiment, the extension portion 14b extends from the body portion 14a towards a position between the light guide plate 121 and one of the at least two side walls 111 without the backlight source 13. That is, the backlight source 13 may be arranged between a side of the light guide plate 121 and one of the at least two side walls 111, whereas the extension portion 14b may be arranged between another side of the light guide plate 121 and another one of the at least two side walls 111.

Alternatively, the positioning member 14 may be aligned with a side of the top wall 113 away from the receiving space 101, such that the positioning member 14 and the top wall 113 may cooperatively carry the display module of the electronic device. In the present embodiment, the body portion 14a may be aligned with the side of the top wall 113 away from the receiving space 101.

Further, the positioning member 14 is arranged with a second positioning portion 141 perpendicularly protruding from an end of the extension portion 14b, and the second positioning portion 141 is engaged with the first positioning portion 1213, such that the distance between the light guide plate 121 and the backlight source 13 is less than or equal to a threshold.

It may be understood, during assembling the backlight module 10, the backlight source 13 may be disposed into the receiving space 101 of the back frame 11 firstly, and the optical assembly 12 may subsequently be disposed into the receiving space 101. At this point, an assembly gap may be reserved between the light guide plate 121 of the optical assembly 12 and the backlight source 13. That is, after disposing the optical assembly 12 into the receiving space 101, a gap may be defined between the light guide plate 121 and the backlight source 13. However, during an actual assembling process, after the optical assembly 12 being disposed into the receiving space 101, the gap between the light guide plate 121 and the backlight source 13 may be too large, such that the light guide plate 121 may not be able to receive the light emitted from the backlight source 13 completely, reducing the backlight effect of the light guide plate 121. In the present embodiment, the second positioning portion 141 of the positioning member 14 is arranged to engage with the first positioning portion 1213 of the light guide portion 121. During engagement, the optical assembly 12 may disposed into the receiving space 101 by means of engaging the first positioning portion 1213 with the second positioning portion 141, such that the distance between the light guide plate 121 and the backlight source 13 is less than or equal to the threshold. A situation of the distance between the light guide plate 121 and the backlight source 13 being too long may be avoided during the assembling, assembly precision may be improved, and a difficulty of assembling may be reduced.

The second positioning portion 141 is a protrusion perpendicularly protruding from an end of the extension portion 14b and engaged with the first positioning portion 1213 (such as the recess in the present embodiments), and a direction of the protrusion protruding towards the recess is parallel to an extending direction of the backlight source 13.

Alternatively, the threshold may be less than or equal to 0.1mm.

Further, in the present embodiment, the backlight module 10 may further include a light-shielding tape 17. The light-shielding tape 17 may be arranged on the side of the top wall 113 away from the receiving space 101 and may be adhered to the top wall 113 and the optical film assembly 122. In such a way, when the backlight source 13 is emitting light, and the light is transmitting through the light guide plate 121 to reach the optical film assembly 122, the light may not be escaped from the optical film assembly 122.

Specifically, the light-shielding tape 17 may be arranged on the side of the top wall 113 away from the receiving space 101, and may be adhered to the tope wall 113 and upper transmission increasing film 122c of the optical film assembly 122.

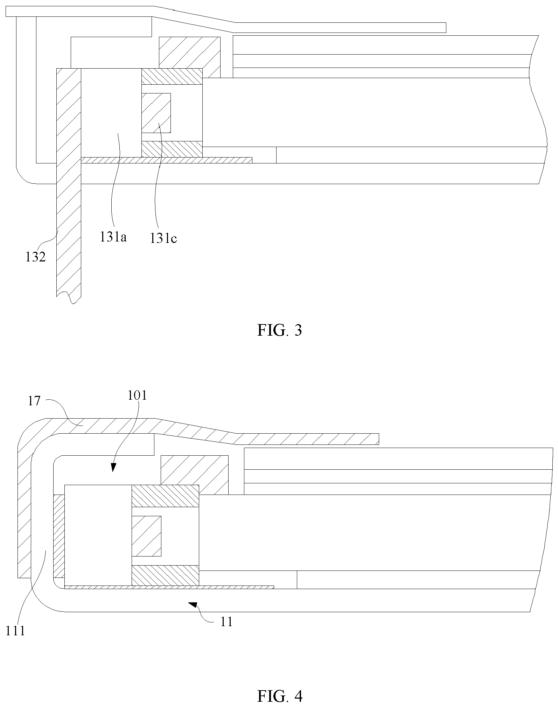

As shown in FIG. 4, in other embodiments, the light-shielding tape 17 may be adhered to a side of the side wall 111 away from the receiving space 101 to increase an adhesion area between the light-shielding tape 17 and the back frame 11, such that an adhesive force between the light-shielding tape 17 and the back frame 11 may be improved.

According to the backlight module provided in the present embodiment, the light guide plate is arranged with the first positioning portion, and the positioning member is arranged with the second positioning portion engaged with the first positioning portion, such that, during assembling the optical assembly, the first positioning portion and the second positioning portion are engaged to achieve positioning, and the optical assembly is disposed into the receiving space, such that the distance between the light guide plate and the backlight source is less than or equal to the threshold. In such a way, during assembling, a situation of the distance between the light guide plate and the backlight source being too long may be avoided, and the light guide plate unable to completely receive the light emitted from the backlight source may be avoided, improving the backlight effect of the light guide plate, improving the assembly accuracy, and reducing the difficulty of assembling.

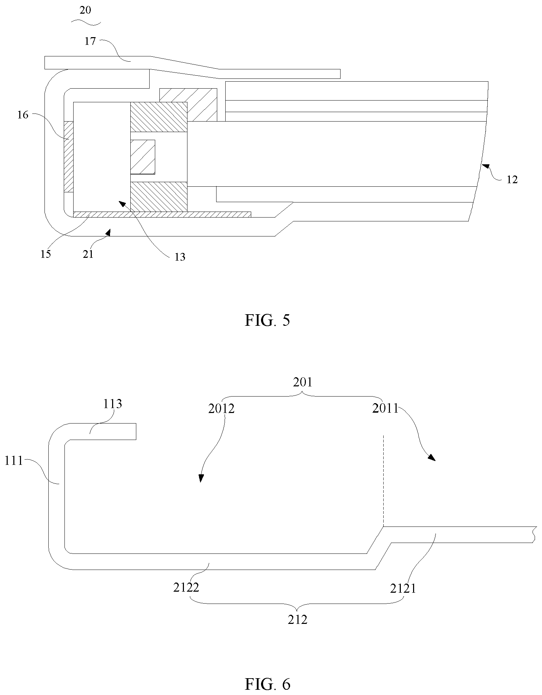

As shown in FIG. 5, a cross-sectional view of the backlight module 20 according to the second embodiment is provided. The backlight module 20 includes a back frame 21, an optical assembly 12, a backlight source 13, and a positioning member 14.

As shown in FIG. 5 and FIG. 6, the back frame 21 includes a side wall 111 and a bottom wall 212. The side wall 111 and the bottom wall 212 are bent and connected to each other to define a receiving space 201.

At least two the side walls 111 are arranged, bent and connected to each other.

Alternatively, the back frame 21 may further include a top wall 113, and the top wall 113 and an end of the side wall 111 away from the bottom wall 212 may be bent and connected to each other. The top wall 113, the side wall 111, and the bottom wall 212 may cooperatively define the receiving space 201. The top wall 113 may be arranged to support a display module while assembling the backlight module 10 with the display module of the electronic device.

The receiving space 201 may include a first space 2011 and a second space 2012 communicating with each other, and the first space 2011 and the second space 2012 may be defined sequentially along a direction facing towards the side wall 111. An area of a cross section of the second space 2012 taken along a direction facing the side wall 111 is greater than that of the first space 2011 taken along a direction facing the side wall 111.

Specifically, the bottom wall 212 may include a first bottom wall 2121 and a second bottom wall 2122. The first bottom wall 2121 and the second bottom wall 2122 are connected to each other and arranged sequentially along a direction facing towards the side wall 111. As shown in FIG. 6, a vertical distance between the second bottom wall 2122 and the top wall 113 may be greater than a vertical distance between the first bottom wall 2121 and the top wall 113. In such a way, when the receiving space 201 is defined, cross sections of the first and the second spaces may be taken along the direction facing towards the side wall 111, the area of the cross section of the second space 2012 defined by the second side wall 2122 may be greater than that of the first space 2011 defined by the first side wall 2121.

Further, the back frame 21 may define an opening 1111 communicating with the receiving space 201.

Alternatively, the back frame 21 may be a metal back frame.

The optical assembly 12 is received in the receiving space 201 and is arranged on the bottom wall 212.

Specifically, the optical assembly 12 may be received in the first space 2011 of the receiving space 201.

The optical assembly 12 includes a light guide plate 121. The light guide plate 121 may include a light incidence surface 1211 and a light emitting surface 1212. The light incidence surface 1211 may be a side of the light guide plate 121 close to the side wall 111, and the light emitting surface 1212 may be a side of the light guide plate 121 away from the bottom wall 212. Further, the light guide plate 121 is arranged with a first positioning portion 1213.

The first positioning portion is a recess.

Further, the optical assembly 12 may further include an optical film assembly 122 and a reflection sheet 123. The optical film assembly 122 may be arranged on the light guide plate 121 and may specifically be on the light emitting surface 1212 of the light guide plate 121. The reflection sheet 123 may be arranged on the bottom wall 212 facing towards a side of the light guide plate 121 away from the light emitting surface 1212.

The optical film assembly 122 may include a diffusion film 122a, a lower transmission increasing film 122b, and an upper transmission increasing film 122c sequentially stacked along a direction away from the light guide plate 121.

The backlight source 13 is arranged on the side of the light guide plate 121 close to the side wall 111. Specifically, the backlight source 13 is arranged on the side of the light guide plate 121 close to one of the at least two side walls 111.

The backlight source 13 includes a lamp 131 and a flexible circuit board 132.

The lamp 131 is arranged on the side of the light guide plate 121 close to the side wall 111. Specifically, the lamp 131 may be arranged on the light incidence surface 1211 of the light guide plate 121 to emit light to the light guide plate 121 through the light incidence surface 1211.

Further, the light source 131 may be received in the second space 2012.

The lamp 131 may include a PCB 131a, an encapsulation member 131b, and a light emitting element 131c. The PCB 131a may be arranged on the side of the light guide plate 121 close to the side wall 111. The encapsulation member 131b may be arranged on a side of the PCB 131a close to the light guide plate 121 and connected to the PCB 131a. The encapsulation member 131b may define an encapsulation groove 1311. The light emitting element 131c may be adhered to the PCB 131a and may be received in the encapsulation groove 1311. The light emitting element 131c may emit the light to the light guide plate 121 through the encapsulation groove 1311.

Alternatively, the light emitting element 131c may be an LED chip.

Further, the lamp 131 may be arranged at an optimized position for light emitting relative to the light guide plate 121.

The optimized position for light emitting may be a position of the lamp 131 from which the light emitted may be completely received by the guide plate 121. The optimized position may be an optimized position in height and in distance. It may be understood that, when the lamp 131 is arranged at a position being too high or too low along a direction perpendicular to the bottom wall 212, the light guide plate 121 may be unable to receive the light emitted from the lamp 131 completely. When a distance between the lamp 131 and the light guide plate 121 is too long, the light emitted from the lamp 131 may escape from the light guide plate 121, and therefore, the light may not be completely received by the light guide plate 121, such that utilization of the light source 131 and the backlight effect of the light guide plate 121 may be reduced.

Alternatively, the light emitting element 131c of the lamp 131 may be arranged on a central line of the light guide plate 121.

Alternatively, a first adhesion member 15 may be arranged between the lamp 131 and the bottom wall 212. The lamp 131 may be adhered to the bottom wall 212 via the first adhesion member 15, enabling the lamp 131 to be arranged at the optimized position in height relative to the light guide plate 121. That is, in the present embodiment, when the lamp 131 is adhered on the bottom wall 212 and fixed relative to the bottom wall 212 via the first adhesion member 15, a thickness of the first adhesion member 15 may be adjusted to enable the lamp 131 to be arranged at the optimized position in height relative to the light guide plate 121, such that utilization of the light source 131 and the backlight effect of the light guide plate 121 may be improved.

Further, as the light 131 may be received in the second space 2012, and the area of the cross section of the second space 2012 taken along the direction perpendicular to the side wall 111 is greater than that of the first space 2011 taken along the direction perpendicular to the side wall 111, when a height of the light 131 relative to the light guide plate 121 is adjusted, an enough space for adjustment may be defined. A situation of defining insufficient space for adjustment may be avoided. When the space for adjustment is insufficient, a thickness of the first adhesion member 15 may be reduced, a small thickness of the first adhesion member 15 may reduce an adhesive force between the light 131 and the bottom wall 212. Alternatively, under such the situation of insufficient space for adjustment, the light 131 may not be arranged at the optimized position to prevent the thickness of the first adhesion member 15 from being too small, reducing the backlight effect of the light guide plate 121.

Alternatively, the first adhesion member 15 may be a double-sided tape.

Alternatively, a second adhesion member 16 may be arranged between the lamp 131 and the side wall 111. The lamp 131 may be adhered to the side wall 111 via the second adhesion member 16, enabling the lamp 131 to be arranged at the optimized position in distance relative to the light guide plate 121. That is, in the present embodiment, when the lamp 131 is adhered on the side wall 111 and fixed relative to the side wall 111 via the second adhesion member 16, a thickness of the second adhesion member 16 may be adjusted to enable the lamp 131 to be arranged at the optimized distance relative to the light guide plate 121, such that utilization of the light 131 and the backlight effect of the light guide plate 121 may be improved.

The flexible circuit board 132 may be arranged to adhere to a side of the lamp 131 away from the light guide plate 121, such that a space for soldering the flexible circuit board 132 with the lamp 131 may not be required along a direction facing towards the side wall 111. Therefore, the space may be saved along the direction perpendicular to the side wall 111, a width of the backlight module 10 along the direction perpendicular to the side wall 111 may be reduced, and the backlight module having a narrow side maybe achieved.

Specifically, the flexible circuit board 132 may be adhered to a side of the PCB 131a away from the light emitting element 131c. The flexible circuit board may extend through the opening 1111 to reach a side of the back frame 11 away from the receiving space 101.

The flexible circuit board 132 and the second adhesion member 15 may both be adhered to the PCB 131a.

The positioning member 14 is connected to the back frame 11 and at least partially received in the receiving space 201.

Specifically, the positioning member 14 includes a body portion 14a and an extension portion 14b. The body portion 14a is connected to the back frame 11. The extension portion 14b extends from the body portion 14a towards the receiving space 201. The positioning member 14 in the second embodiment is similar to that in the first embodiment, and by referring to FIG. 1, the body portion 14a is at least partially received in the receiving space 201 and connects to the back frame 11. The extension portion 14b extends from a part of the body portion 14a received in the receiving space 201.

The body portion 14a is arranged at a position of which the at least two side walls 111 are bent and connected. The extension portion 14b extends from the body portion 14a towards a position between the light guide plate 121 and at least one of the at least two side walls 111. In the present embodiment, the extension portion 14b extends from the body portion 14a towards a position between the light guide plate 121 and one of the at least two side walls 111 without the backlight source 13. That is, the backlight source 13 may be arranged between a side of the light guide plate 121 and one of the at least two side walls 111, whereas the extension portion 14b may be arranged between another side of the light guide plate 121 and another one of the at least two side walls 111.

Alternatively, the positioning member 14 may be aligned with the side of the top wall 113 away from the receiving space 201, such that the positioning member 14 and the top wall 113 may cooperatively carry the display module of the electronic device. In the present embodiment, the body portion 14a may be aligned with the side of the top wall 113 away from the receiving space 201.

Further, the positioning member 14 is arranged with a second positioning portion 141, and the second positioning portion 141 is engaged with the first positioning portion 1213, such that the distance between the light guide plate 121 and the backlight source 13 is less than or equal to a threshold.

It may be understood, during assembling the backlight module 10, the backlight 13 may be disposed into the receiving space 201 of the back frame 11 first, and the optical assembly 12 may subsequently be disposed into the receiving space 201. At this point, an assembly gap may be reserved between the light guide plate 121 of the optical assembly 12 and the backlight 13. That is, after disposing the optical assembly 12 into the receiving space 201, a gap may be defined between the light guide plate 121 and the backlight source 13. However, during an actual assembling process, after the optical assembly 12 being disposed into the receiving space 201, the gap between the light guide plate 121 and the backlight 13 may be too large, such that the light guide plate 121 may not be able to receive the light emitted from the backlight source 13 completely, reducing the backlight effect of the light guide plate 121. In the present embodiment, the second positioning portion 141 of the positioning member 14 is arranged to engage with the first positioning portion 1213 of the light guide portion 121. During engagement, the optical assembly 12 may disposed into the receiving space 101 by means of engaging the first positioning portion 1213 with the second positioning portion 141, such that the distance between the light guide plate 121 and the backlight source 13 is less than or equal to the threshold. A situation of the distance between the light guide plate 121 and the backlight source 13 being too long may be avoided during the assembling, assembly precision may be improved, and a difficulty of assembling may be reduced.

The second positioning portion 141 is a protrusion engaged with the recess of the first positioning portion 1213, and a direction the protrusion protruding towards the recess is parallel to an extending direction of the backlight source 13.

Alternatively, the threshold may be less than or equal to 0.1mm.

Further, in the present embodiment, the backlight module 20 may further include a light-shielding tape 17. The light-shielding tape 17 may be arranged on the side of the top wall 113 away from the receiving space 201 and may be adhered to the top wall 113 and the optical film assembly 122. In such a way, when backlight source 13 is emitting light, and the light is transmitting through the light guide plate 121 reaching the optical film assembly 122, the light may not be escaped from the optical film assembly 122.

Specifically, the light-shielding tape 17 may be arranged on the side of the top wall 113 away from the receiving space 201, and may be adhered to the tope wall 113 and upper transmission increasing film 122c of the optical film assembly 12.

Alternatively, in other embodiments, the light-shielding tape 17 may be adhered to a side of the side wall 111 away from the receiving space 201 to increase an adhesion area between the light-shielding tape 17 and the back frame 11, such that an adhesive force between the light-shielding tape 17 and the back frame 11 may be improved.

According to the backlight module provided in the present embodiment, the light guide plate is arranged with the first positioning portion, and the positioning member is arranged with the second positioning portion engaged with the first positioning portion, such that, during assembling the optical assembly, the first positioning portion and the second positioning portion engage to achieve positioning. The optical assembly is disposed into the receiving space, such that the distance between the light guide plate and the backlight source is less than or equal to the threshold. In such a way, during assembling, a situation of the distance between the light guide plate and the backlight source being too long may be avoided, and the light guide plate unable to receive the light emitted from the backlight source may be avoided, improving the backlight effect of the light guide plate, improving the assembly accuracy, and reducing the difficulty of assembling. Further, the lamp may be disposed in the second space, the area of the cross section of the second space taken along the direction facing towards the side wall is greater than that of the first space taken along the direction facing towards the side wall. When the height of the lamp relative to the bottom wall is adjusted, sufficient space may be defined. A situation of insufficient space for adjustment may be avoided, and reducing the thickness of the first adhesion member resulting in reduction of the adhesive force between the lamp and the bottom wall may be prevented. Alternatively, a situation of arranging the adhesion member in a proper thickness but resulting in the lamp missing the optimized position in height and reducing the backlight effect may be prevented.

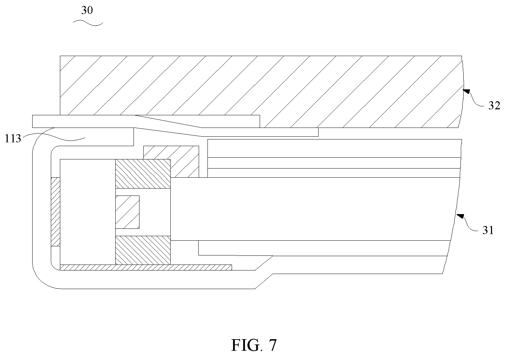

As shown in FIG. 7, a structural diagram of an electronic device 30 is provided according to an embodiment. The electronic device in the present embodiment may be any device having functions of communication and storage, such as a tablet computer, a mobile phone, an electronic reader, a network television, a wearable device, and other intelligent devices able to connect to the network.

The electronic device 30 may include the backlight module 31 as described in any one of the above-mentioned embodiments and a display module 32. The backlight module 31 may refer to detailed description of any one of the above-mentioned embodiments, and will not be repeatedly described hereinafter. The backlight module 20 described in the second embodiment may be shown in the figure of the present embodiment.

The display module 32 may be arranged to stack above the backlight module 31.

Further, the display module 32 may be carried by the top wall 113.

Only a part of embodiments are described in the above, and should not limit the scope of the present disclosure.

## Claims

1. A backlight module (10), comprising:
a back frame (11), comprising a side wall (111) and
a bottom wall (112), wherein the side wall (111) and the bottom wall (112) are bent to connect to each other and define a receiving space (101);
an optical assembly (12), arranged on the bottom wall (112) and received in the receiving space (101), wherein the optical assembly (12) comprises a light guide plate (121), and the light guide plate (121) defines a recess (1213);
a backlight source (13), comprising a lamp (131) and a flexible circuit board (132), wherein the lamp (131) is arranged on and extends along a side of the light guide plate (121) close to the side wall (111); and
a positioning member (14), arranged to connect to the back frame (11) and at least partially received in the receiving space (101), wherein the positioning member (14) comprises a positioning portion (141), the positioning portion (141) is a protrusion having a shape corresponding to the recess and engaged into the recess (1213), and an extending direction of the positioning portion (141) is parallel to an extending direction of the lamp (131), such that a distance between the light guide plate (121) and the backlight source (13) is less than or equal to a threshold;
wherein the positioning member (14) further comprises a body portion (14a) and an extension portion (14b), the body portion (14a) is connected to the back frame (11), the extension portion (14b) is arranged to extend from the body portion (14a) towards the positioning portion (141) in the receiving space (101), and the positioning portion (141) is arranged on the extension portion (14b); the side wall (111) comprises at least two side walls (111), the at least two side walls (111) are bent to connect to each other, the body portion (14a) is arranged at a position at which the at least two side walls (111) are connected to each other, and the extension portion (14b) is arranged to extend from the body portion (14a) at a position between the light guide plate (121) and at least one of the at least two side walls (111).

2. The backlight module (10) according to claim 1, wherein the positioning portion (141) is arranged to perpendicularly protrude from an end of the extension portion (14b) away from the body portion (14a).

3. The backlight module (10) according to claim 1, wherein
the back frame (11) further comprises a top wall (113);
the top wall (113) and an end of the side wall (111) away from the bottom wall (112) are bent to connect to each other;
the top wall (113), the side wall (111), and the bottom wall (112) cooperatively define the receiving space (101); and
the positioning member (14) is arranged to align with the top wall (113).

4. The backlight module (10) according to any one of claims 1 to 3, wherein the threshold is less than or equal to 0.1mm.

5. The backlight module (10) according to any one of claims 1 to 4, wherein the flexible circuit board (132) is adhered to a side of the lamp (131) away from the light guide plate (121).

6. The backlight module (10) according to claim 5, wherein the light guide plate (121) comprises a light incidence surface (1211) and a light emitting surface (1212), the lamp (131) is arranged on the light incidence surface (1211) of the light guide plate (121) and at an optimized position for light emitting, and the optimized position for light emitting is an optimized position of the lamp (131) in height and in distance relative to the light guide plate (121), enabling emitted light to be completely received by the light guide plate (121).

7. The backlight module (10) according to claim 6, wherein a first adhesion member (15) is arranged between the lamp (131) and the bottom wall (112), and the lamp (131) is adhered to the bottom wall (112) via the first adhesion member (15), such that the lamp (131) is arranged at the optimized position in height relative to the light guide plate (121) by providing the first adhesion member (15) in an appropriate thickness.

8. The backlight module (10) according to claim 6 or claim 7, wherein a second adhesion member (16) is arranged between the lamp (131) and the side wall (111), and the lamp (131) is adhered to the side wall (111) via the second adhesion member (16), such that the lamp (131) is arranged at the optimized position in distance relative to the light guide plate (121) by providing the second adhesion member (16) in an appropriate thickness.

9. The backlight module (10) according to any one of claims 5 to 8, wherein the receiving space (101) comprises a first space (2011) and a second space (2012) communicating with each other, the first space (2011) and the second space (2012) are sequentially defined along a direction facing towards the side wall (111), the optical assembly (12) is received in the first space (2011), the height of a cross section of the second space (2012) taken along the direction facing towards the side wall (111) is greater than that of the first space (2011) taken along the facing towards the side wall (111), wherein the height is measured along a direction perpendicular to the direction facing the side wall and the lamp (131) is received in the second space (2012).

10. The backlight module (10) according to any one of claims 3 to 9, wherein the optical assembly (12) further comprises an optical film assembly (122) arranged on the light emitting surface (1212) of the light guide plate (121), the backlight module (10) further comprises a light-shielding tape (17), and the light-shielding tape (17) is arranged on a side of the top wall (113) away from the receiving space (101) and adhered to the top wall (113) and the optical film assembly (122).

11. The backlight module (10) according to claim 10, wherein the light-shielding tape (17) is further arranged on a side of the side wall (111) away from the receiving space (101) and adhered to the side wall (111).

12. An electronic device (30), **characterized by** comprising a display module (32) and the backlight module (10) according to any one of claims 1 to 11, wherein the display module (32) is arranged to stack above the backlight module (10).

## Patentansprüche

1. Hintergrundbeleuchtungsmodul (10), Folgendes umfassend:
einen Hinterrahmen (11), eine Seitenwand (111) und eine Bodenwand (112) umfassend, wobei die Seitenwand (111) und die Bodenwand (112) gebogen sind, um sich miteinander zu verbinden und einen Aufnahmeraum (101) zu definieren;
eine optische Anordnung (12), die auf der Bodenwand (112) angeordnet ist und in dem Aufnahmeraum (101) aufgenommen ist, wobei die optische Anordnung (12) eine Lichtleiterplatte (121) umfasst und die Lichtleiterplatte (121) eine Aussparung (1213) definiert;
eine Hintergrundbeleuchtungsquelle (13), eine Lampe (131) und eine flexible Leiterplatte (132) umfassend, wobei die Lampe (131) auf einer Seite der Lichtleiterplatte (121) nahe der Seitenwand (111) angeordnet ist und sich entlang dieser erstreckt; und
ein Positionierelement (14), das angeordnet ist, um sich mit dem Hinterrahmen (11) zu verbinden, und mindestens teilweise in dem Aufnahmeraum (101) aufgenommen ist, wobei das Positionierelement (14) einen Positionierabschnitt (141) umfasst, wobei der Positionierabschnitt (141) eine Vorwölbung mit einer Gestalt ist, die der Aussparung entspricht und in die Aussparung (1213) eingreift, und
wobei eine Ausdehnungsrichtung des Positionierabschnitts (141) zu einer Ausdehnungsrichtung der Lampe (131) parallel ist, so dass ein Abstand zwischen der Lichtleiterplatte (121) und der Hintergrundbeleuchtungsquelle (13) kleiner oder gleich einem Schwellenwert ist;
wobei das Positionierelement (14) weiterhin einen Grundkörperabschnitt (14a) und einen Erweiterungsabschnitt (14b) umfasst, der Grundkörperabschnitt (14a) mit dem Hinterrahmen (11) verbunden ist, der Erweiterungsabschnitt (14b) angeordnet ist, um sich aus dem Grundkörperabschnitt (14a) in Richtung auf den Positionierabschnitt (141) in dem Aufnahmeraum (101) zu erstrecken, und der Positionierabschnitt (141) auf dem Erweiterungsabschnitt (14b) angeordnet ist; die Seitenwand (111) mindestens zwei Seitenwände (111) umfasst, die mindestens zwei Seitenwände (111) gebogen sind, um sich miteinander zu verbinden, der Grundkörperabschnitt (14a) an einer Position angeordnet ist, an der die mindestens zwei Seitenwände (111) miteinander verbunden sind, und der Erweiterungsabschnitt (14b) angeordnet ist, um sich von dem Grundkörperabschnitt (14a) zu einer Position zwischen der Lichtleiterplatte (121) und mindestens einer der mindestens zwei Seitenwände (111) zu erstrecken.

2. Hintergrundbeleuchtungsmodul (10) nach Anspruch 1, wobei der Positionierabschnitt (141) angeordnet ist, um senkrecht aus einem Ende des Erweiterungsabschnitts (14b) von dem Grundkörperabschnitt (14a) weg vorzustehen.

3. Hintergrundbeleuchtungsmodul (10) nach Anspruch 1, wobei
der Hinterrahmen (11) weiterhin eine Deckwand (113) umfasst;
die Deckwand (113) und ein Ende der Seitenwand (111) weg von der Bodenwand (112) gebogen sind, um sich miteinander zu verbinden;
die Deckwand (113), die Seitenwand (111) und die Bodenwand (112) gemeinsam den Aufnahmeraum (101) definieren; und
das Positionierelement (14) angeordnet ist, um mit der Deckwand (113) ausgerichtet zu sein.

4. Hintergrundbeleuchtungsmodul (10) nach einem der Ansprüche 1 bis 3, wobei der Schwellenwert kleiner oder gleich 0,1 mm ist.

5. Hintergrundbeleuchtungsmodul (10) nach einem der Ansprüche 1 bis 4, wobei die flexible Leiterplatte (132) an einer Seite der Lampe (131) weg von der Lichtleiterplatte (121) angeklebt ist.

6. Hintergrundbeleuchtungsmodul (10) nach Anspruch 5, wobei die Lichtleiterplatte (121) eine Lichteinfalloberfläche (1211) und eine lichtemittierende Oberfläche (1212) umfasst, die Lampe (131) auf der Lichteinfalloberfläche (1211) der Lichtleiterplatte (121) und an einer optimierten Position zum Emittieren von Licht angeordnet ist und die optimierte Position zum Emittieren von Licht eine optimierte Höhen- und Abstandsposition der Lampe (131) in Bezug auf die Lichtleiterplatte (121) ist, die ermöglicht, dass emittiertes Licht vollständig von der Lichtleiterplatte (121) aufgenommen wird.

7. Hintergrundbeleuchtungsmodul (10) nach Anspruch 6, wobei ein erstes Klebeelement (15) zwischen der Lampe (131) und der Bodenwand (112) angeordnet ist und die Lampe (131) über das erste Klebeelement (15) derartig an die Bodenwand (112) geklebt ist, dass die Lampe (131) an der optimierten Höhenposition relativ zu der Lichtleiterplatte (121) angeordnet ist, indem das erste Klebeelement (15) in einer geeigneten Dicke bereitgestellt wird.

8. Hintergrundbeleuchtungsmodul (10) nach Anspruch 6 oder 7, wobei ein zweites Klebeelement (16) zwischen der Lampe (131) und der Seitenwand (111) angeordnet ist und die Lampe (131) über das zweite Klebeelement (16) derartig an die Seitenwand (111) geklebt ist, dass die Lampe (131) an der optimierten Abstandsposition relativ zu der Lichtleiterplatte (121) angeordnet ist, indem das zweite Klebeelement (16) mit einer geeigneten Dicke bereitgestellt wird.

9. Hintergrundbeleuchtungsmodul (10) nach einem der Ansprüche 5 bis 8, wobei der Aufnahmeraum (101) einen ersten Raum (2011) und einen zweiten Raum (2012) umfasst, die miteinander in Verbindung stehen, der erste Raum (2011) und der zweite Raum (2012) entlang einer Richtung sequenziell definiert sind, die auf die Seitenwand (111) zeigt, die optische Anordnung (12) in dem ersten Raum (2011) aufgenommen ist, die Höhe eines Querschnitts des zweiten Raums (2012), der entlang der Richtung genommen ist, die auf die Seitenwand (111) zeigt, größer ist als der des ersten Raums (2011), der entlang der Richtung genommen ist, die auf die Seitenwand (111) zeigt, wobei die Höhe entlang einer Richtung senkrecht zu der Richtung gemessen wird, die auf die Seitenwand zeigt, und die Lampe (131) in dem zweiten Raum (2012) aufgenommen ist.

10. Hintergrundbeleuchtungsmodul (10) nach einem der Ansprüche 3 bis 9, wobei die optische Anordnung (12) weiterhin eine optische Filmanordnung (122) umfasst, die auf der lichtemittierenden Oberfläche (1212) der Lichtleiterplatte (121) angeordnet ist, das Hintergrundbeleuchtungsmodul (10) weiterhin ein Lichtabschirmband (17) umfasst und das Lichtabschirmband (17) auf einer Seite der Deckwand (113) weg von dem Aufnahmeraum (101) angeordnet ist und an die Deckwand (113) und an die optische Filmanordnung (122) geklebt ist.

11. Hintergrundbeleuchtungsmodul (10) nach Anspruch 10, wobei das Lichtabschirmband (17) weiterhin auf einer Seite der Seitenwand (111) weg von dem Aufnahmeraum (101) angeordnet ist und an die Seitenwand (111) geklebt ist.

12. Elektronische Vorrichtung (30), **dadurch gekennzeichnet, dass** sie ein Anzeigemodul (32) und das Hintergrundbeleuchtungsmodul (10) nach einem der Ansprüche 1 bis 11 umfasst, wobei das Anzeigemodul (32) über dem Hintergrundbeleuchtungsmodul (10) gestapelt angeordnet ist.

## Revendications

1. Module de rétroéclairage (10) comprenant :
un cadre arrière (11), comprenant une paroi latérale (111) et
une paroi inférieure (112), la paroi latérale (111) et la paroi inférieure (112) étant pliées pour se connecter l'une à l'autre et définir un espace de réception (101) ;
un ensemble optique (12), agencé sur la paroi inférieure (112) et reçu dans l'espace de réception (101), l'ensemble optique (12) comprenant une plaque de guidage de la lumière (121), et la plaque de guidage de la lumière (121) définissant un renfoncement (1213) ;
une source de rétroéclairage (13), comprenant une lampe (131) et une carte de circuits imprimés souple (132), la lampe (131) étant agencée sur un côté de et s'étendant le long d'un côté de la plaque de guidage de la lumière (121) proche de la paroi latérale (111) ; et
un élément de positionnement (14), agencé pour être relié au cadre arrière (11) et au moins partiellement reçu dans l'espace de réception (101), l'élément de positionnement (14) comprenant une partie de positionnement (141), la partie de positionnement (141) étant une protubérance ayant une forme correspondant au renfoncement et en prise dans le renfoncement (1213), et
une direction d'extension de la partie de positionnement (141) étant parallèle à une direction d'extension de la lampe (131), de sorte qu'une distance entre la plaque de guidage de la lumière (121) et la source de rétroéclairage (13) est inférieure ou égale à un seuil ;
l'élément de positionnement (14) comprenant en outre une partie de corps (14a) et une partie d'extension (14b), la partie de corps (14a) étant reliée au cadre arrière (11), la partie d'extension (14b) étant agencée pour s'étendre de la partie de corps (14a) vers la partie de positionnement (141) dans l'espace de réception (101), et la partie de positionnement (141) étant agencée sur la partie d'extension (14b) ; la paroi latérale (111) comprenant au moins deux parois latérales (111), les au moins deux parois latérales (111) étant pliées pour se connecter l'une à l'autre, la partie de corps (14a) étant agencée à une position à laquelle les au moins deux parois latérales (111) sont connectées l'une à l'autre, et la partie d'extension (14b) étant agencée pour s'étendre à partir de la partie de corps (14a) à une position entre la plaque de guidage de la lumière (121) et au moins l'une des au moins deux parois latérales (111).

2. Module de rétroéclairage (10) selon la revendication 1, la partie de positionnement (141) étant agencée pour faire saillie perpendiculairement à partir d'une extrémité de la partie d'extension (14b) à l'écart de la partie de corps (14a).

3. Module de rétroéclairage (10) selon la revendication 1,
le cadre arrière (11) comprenant en outre une paroi supérieure (113) ;
la paroi supérieure (113) et une extrémité de la paroi latérale (111) à l'écart de la paroi inférieure (112) étant pliées pour se connecter l'une à l'autre ;
la paroi supérieure (113), la paroi latérale (111) et la paroi inférieure (112) définissant conjointement l'espace de réception (101) ; et
l'élément de positionnement (14) étant agencé pour s'aligner sur la paroi supérieure (113).

4. Module de rétroéclairage (10) selon l'une quelconque des revendications 1 à 3, le seuil étant inférieur ou égal à 0,1 mm.

5. Module de rétroéclairage (10) selon l'une quelconque des revendications 1 à 4, la carte de circuit flexible (132) étant collée sur une face de la lampe (131) à l'écart de la plaque de guidage de la lumière (121).

6. Module de rétroéclairage (10) selon la revendication 5, la plaque de guidage de la lumière (121) comprenant une surface d'incidence de la lumière (1211) et une surface d'émission de la lumière (1212), la lampe (131) étant agencée sur la surface d'incidence de la lumière (1211) de la plaque de guidage de la lumière (121) et dans une position optimisée pour l'émission de la lumière, et la position optimisée pour l'émission de la lumière étant une position optimisée de la lampe (131) en hauteur et en distance par rapport à la plaque de guidage de la lumière (121), permettant à la lumière émise d'être complètement reçue par la plaque de guidage de la lumière (121).

7. Module de rétroéclairage (10) selon la revendication 6, un premier élément d'adhésion (15) étant agencé entre la lampe (131) et la paroi inférieure (112), et la lampe (131) étant collée à la paroi inférieure (112) par l'intermédiaire du premier élément d'adhésion (15), de sorte que la lampe (131) est agencée à la position optimisée en hauteur par rapport à la plaque de guidage de la lumière (121) en fournissant le premier élément d'adhésion (15) dans une épaisseur appropriée.

8. Module de rétroéclairage (10) selon la revendication 6 ou la revendication 7, un deuxième élément d'adhésion (16) étant agencé entre la lampe (131) et la paroi latérale (111), et la lampe (131) étant collée à la paroi latérale (111) par l'intermédiaire du deuxième élément d'adhésion (16), de sorte que la lampe (131) est agencée à la position optimisée en distance par rapport à la plaque de guidage de la lumière (121) en fournissant le deuxième élément d'adhésion (16) dans une épaisseur appropriée.

9. Module de rétroéclairage (10) selon l'une quelconque des revendications 5 à 8, l'espace de réception (101) comprenant un premier espace (2011) et un deuxième espace (2012) communiquant entre eux, le premier espace (2011) et le deuxième espace (2012) étant définis séquentiellement le long d'une direction orientée vers la paroi latérale (111), l'ensemble optique (12) étant reçu dans le premier espace (2011), la hauteur d'une section transversale du deuxième espace (2012) prise le long de la direction orientée vers la paroi latérale (111) étant supérieure à celle du premier espace (2011) prise le long de la direction orientée vers la paroi latérale (111), la hauteur étant mesurée le long d'une direction perpendiculaire à la direction orientée vers la paroi latérale, et la lampe (131) étant reçue dans le deuxième espace (2012).

10. Module de rétroéclairage (10) selon l'une quelconque des revendications 3 à 9, l'ensemble optique (12) comprenant en outre un ensemble de film optique (122) agencé sur la surface d'émission de la lumière (1212) de la plaque de guidage de la lumière (121), le module de rétroéclairage (10) comprenant en outre un ruban de protection contre la lumière (17), et le ruban de protection contre la lumière (17) étant agencé sur un côté de la paroi supérieure (113) à l'écart de l'espace de réception (101) et collé à la paroi supérieure (113) et à l'ensemble de film optique (122).

11. Module de rétroéclairage (10) selon la revendication 10, la bande de protection contre la lumière (17) étant en outre agencée sur un côté de la paroi latérale (111) à l'écart de l'espace de réception (101) et collée à la paroi latérale (111).

12. Dispositif électronique (30), **caractérisé en ce qu'**il comprend un module d'affichage (32) et le module de rétroéclairage (10) selon l'une quelconque des revendications 1 à 11, le module d'affichage (32) étant agencé pour s'empiler au-dessus du module de rétroéclairage (10).
